# EUROPEAN PATENT SPECIFICATION

(11) **EP 0 549 262 B1**
(45) Date of publication and mention of the grant of the patent: **10.05.1995**
(21) Application number: 92311524.0
(22) Date of filing: 17.12.1992
(51) Int. Cl.: H05K 3/34, B23K 35/38

(54) **Method of soldering**
Lötverfahren
Procédé de soudage

(30) Priority: 20.12.1991 JP 338422/91
(43) Date of publication of application: 30.06.1993
(73) Proprietor: OSAKA SANSO KOGYO LIMITED, Osaka 593 (JP)
(72) Inventor: Tsujimoto, Yoshiharu, Hyogo Pref., (JP); Takenaka, Iku, Otsu City, Shiga Pref., (JP); Onishi, Hiromitsu, Itami City, Hyogo (JP); Chang, Edward K., New Providence, NJ07974 (US)
(74) Representative: Wickham, Michael

(56) References cited:
- EP-A- 0 389 218
- EP-A- 0 410 623
- AT&T TECHNICAL JOURNAL vol. 71, no. 2, March 1992, SHORT HILLS, NJ, US pages 37 - 44 LESLIE A. GUTH ET AL: 'No - Clean Soldering Processes'

## Description

This invention relates to a soldering method for use in mounting electronic parts or components on a printed circuit board for an electronic circuit. These methods upgrade the quality of a soldering procedure.

Hitherto the soldering of electronic parts has been performed in an atmosphere of air with the use of a rosin-based cream solder, thus requiring the use of a high-activity flux. The use of cream solder with a high-activity flux gives generally satisfactory soldering properties, but produces a large amount of residue. This residue needs to be washed away with a suitable solvent such as Freon (RTM) or the like. Freon used in the washing step, however, leads to environmental pollution, and its use has been restricted. In an attempt to eliminate the washing step, a cream solder containing a low-activity flux has been developed and indeed a soldering method using such a cream solder in an inert gas such as nitrogen gas has recently come into practical use.

When a rosin-based cream solder containing a flux with a low solids content is used, reflow soldering is carried out in a nitrogen atmosphere (e.g. EP-A-0 410 623). This soldering procedure in a nitrogen atmosphere enhances soldering properties, and generates minimal residue because of low oxidation activity. The low activity, however, may lead to the occurrence of "solder balls," and if many such solder balls develop, a washing step becomes necessary even though there may be minimal residue. If the parts to be soldered are spaced relatively close together (being of a fine pitch) the cream solder contains smaller solder particles, and in consequence has a higher possibility of producing solder balls.

The present invention aims at making the occurrence of solder balls during reflow soldering less frequent and the quality (e.g. persistent strength) of resulting soldered joins better than in a soldering method performed in a nitrogen gas atmosphere using a rosin cream solder containing a flux with a low solids content. The invention is also intended to attain a better soldering quality by performing soldering with a rosin-based flux containing cream solder, e.g. a fine pitch cream solder, in a special atmospheric gas rather than in air as employed in a customary practice.

The present invention relates to a method of joining a component, e.g. a surface mounted component, to a printed circuit board, which comprises performing reflow soldering with a rosin-based flux containing cream solder in a special atmospheric gas comprising an inert gas such as N₂, Ar or He and containing 10,000 ppm by volume or less of oxygen and 0.5-3.0% by volume of moisture.

The method according to the invention will now be described by way of example with reference to the accompanying drawings.

Figure 1 is an outline view of a preferred embodiment of the present invention.

Figure 2 is an outline view of a preferred embodiment of the present invention.

Figure 3 is a graph showing comparisons in the number of solder balls produced with a rosin-based cream solder containing a flux with a low solids content.

Figure 4 is a graph showing comparisons in the soldered joint strength obtained with a rosin-based cream solder containing a flux with a low solids content.

Figure 5 is a graph showing comparisons in the solder spreading rate obtained with a rosin-based cream solder containing a flux with a low solids content.

Figure 6 is a graph showing comparisons in the number of solder balls produced with a conventional rosin-based cream solder.

Figure 7 is a graph showing comparisons in the soldered joint strength obtained with a conventional rosin-based cream solder.

Figure 8 is a graph showing comparisons in the solder spreading rate obtained with a conventional rosin-based cream solder.

Figure 9 is a graph showing the relationships between the moisture content and each of the soldered joint strength, the number of solder balls, and the solder spreading rate.

The special atmospheric gas may be introduced into the reflow soldering furnace by one of the following methods.
1) High-purity nitrogen gas obtained by vaporising liquid nitrogen by means of an evaporator is passed through a humidifier, and the nitrogen gas containing water vapour is charged into the reflow soldering furnace.
2) Low-purify nitrogen gas generated by a nitrogen generator (PSA, a membrane-equipped apparatus) is passed through a catalyst, where residual oxygen and H₂ are reacted to generate moisture, and at the same time, remove the residual oxygen. Then, the nitrogen gas is introduced into the reflow soldering furnace.

If the oxygen concentration in the special atmospheric gas used in the present invention exceeds 10,000 ppm or the moisture content of the special atmospheric gas is outside the range 0.5-3.0%, the number of solder balls will increase, or the soldering strength will decrease.

Embodiments of the present invention will be described in detail with reference to the appended drawings.

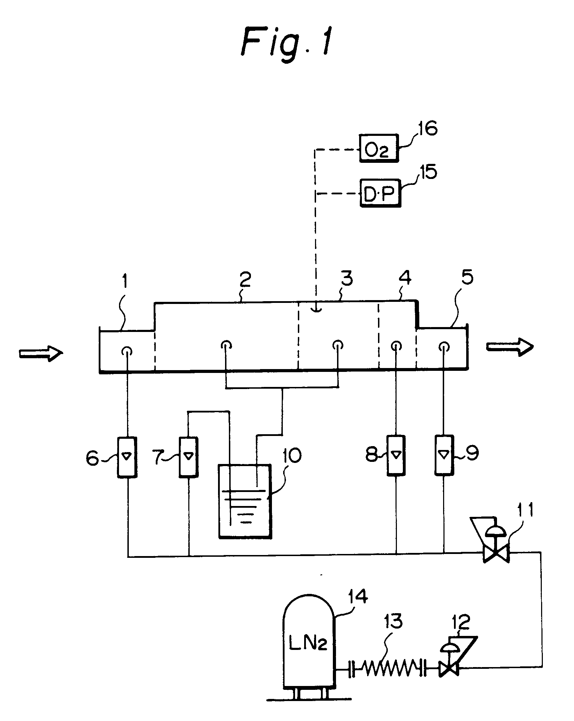

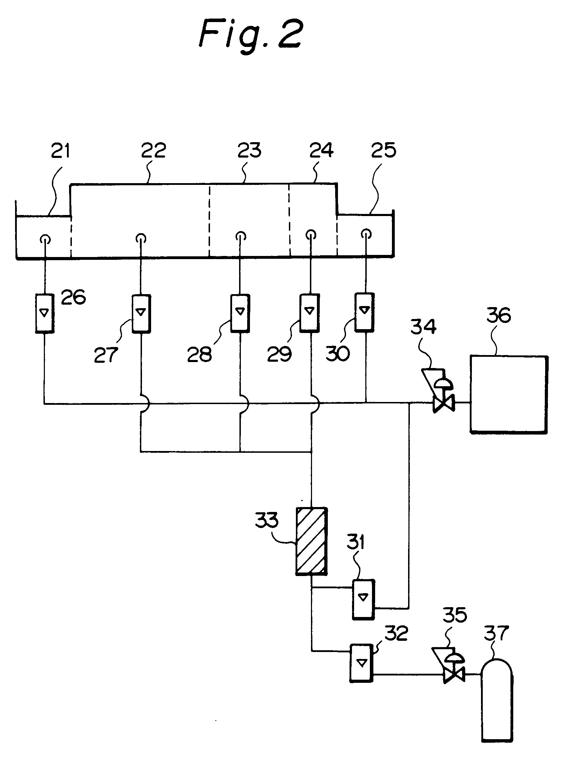

Figure 1 illustrates a method of introducing the special atmospheric gas relevant to the invention into a reflow soldering furnace with the use of liquefied nitrogen and a humidifier. Figure 2 shows a method of feeding the special atmospheric gas, which comprises low-purity nitrogen gas generated by a nitrogen generator (PSA, a membrane-equipped apparatus) and H₂ gas into a reflow soldering furnace after passage through a catalyst.

In Figure 1, liquid nitrogen from a liquid nitrogen tank 14 is passed through an evaporator 13 for vaporisation. The so produced nitrogen gas is led through pressure reducing valves 12 and 11 to nitrogen flow meters 6, 8 and 9 in parallel with one another and fed at a controlled flow rate into respectively an inlet curtain portion 1, a cooling portion 4, and an outlet curtain portion 5 of a reflow soldering furnace. A flow of special atmospheric gas into a preheating portion 2 and a reflow soldering portion 3 of the reflow soldering furnace is formed by passing nitrogen gas through a flowmeter 7 into a humidifier 10 so as to moisturise the nitrogen. The moisture content of the nitrogen gas is controlled by the amount of water, the water temperature, and N₂ gas flow rate in the humidifier 10 so that a moisture content of 0.5-3.0% is attained in the reflow soldering furnace.

The amount of moisture in the furnace is measured by a dew-point hygrometer 15. The flow rate of each gas is controlled so that the oxygen concentration in the furnace as measured by an oxygen meter 16 becomes 10,000 ppm or less.

In Figure 2, low-purity nitrogen gas (0₂ content: 0.5-1.0% by volume) is generated by a nitrogen generator 36. The nitrogen flows through a pressure reducing valve 34. A part of the nitrogen flow passes through a nitrogen flowmeter 31 into a catalytic reactor 33 in the form of a tube. H₂ gas flows from a cylinder 37 through a pressure reducing valve 35 at a flow rate controlled by a flowmeter 32 and passes through the catalyst tube 33. There, the residual oxygen and H₂ are reacted to remove the residual oxygen and generate moisture simultaneously. The rate of passage of nitrogen gas and H₂ gas into the catalytic reactor are controlled using an oxygen meter (not shown) and a dew-point hygrometer (not shown) so that the oxygen concentration in the reflow soldering furnace will be 10,000 ppm or less and the moisture content therein 0.5-3.0%. The thus humidified nitrogen flows from the catalytic reactor 33 through flowmeters 27, 28 and 29 in parallel with one another and thence to, respectively, cooling region 22, soldering region 23, and cooling region 24 of the soldering furnace. That part of the nitrogen stream which by-passes the catalytic reactor 33 is divided into a first subsidiary stream that flows through flowmeter 26 into an inlet curtain region 21 of the furnace and a second subsidiary stream that flows through flowmeter 30 into outlet curtain region 25 of the furnace. The inlet curtain 21 and the outlet curtain 25 are intended to prevent the penetration of air into the furnace from the outside and the flow of nitrogen gas into these curtain regions helps to prevent such ingress of air.

In accordance with the method illustrated in Figure 1, the special atmospheric gas was flowed into the reflow soldering furnace, where an RMA cream solder containing a flux with a low solids content was reflow-soldered first in furnace atmospheres with various different oxygen concentrations in the range of 3 ppm to 21% by volume, a moisture content of 1.5%, and the remainder being nitrogen and then in nitrogen. Then, the number of solder balls, the soldered joint strength, and the solder spreading rate were measured.

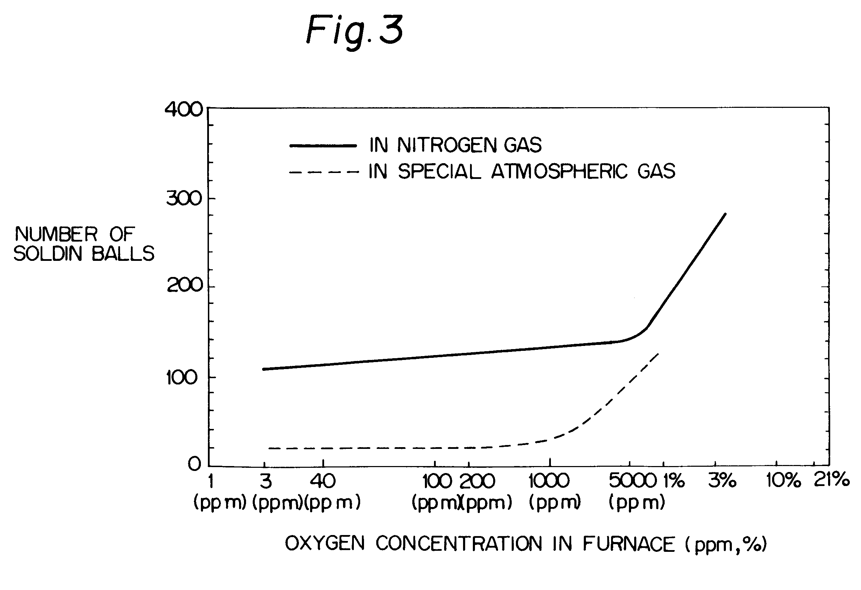

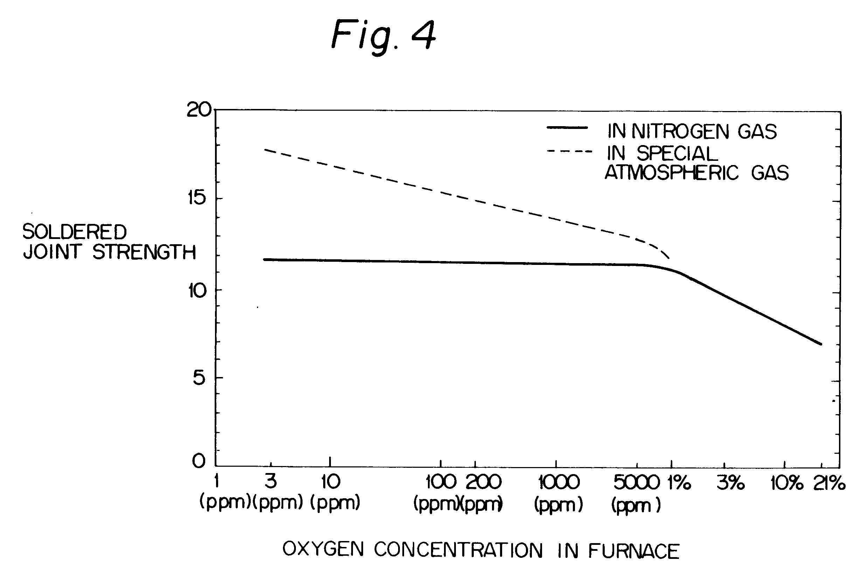

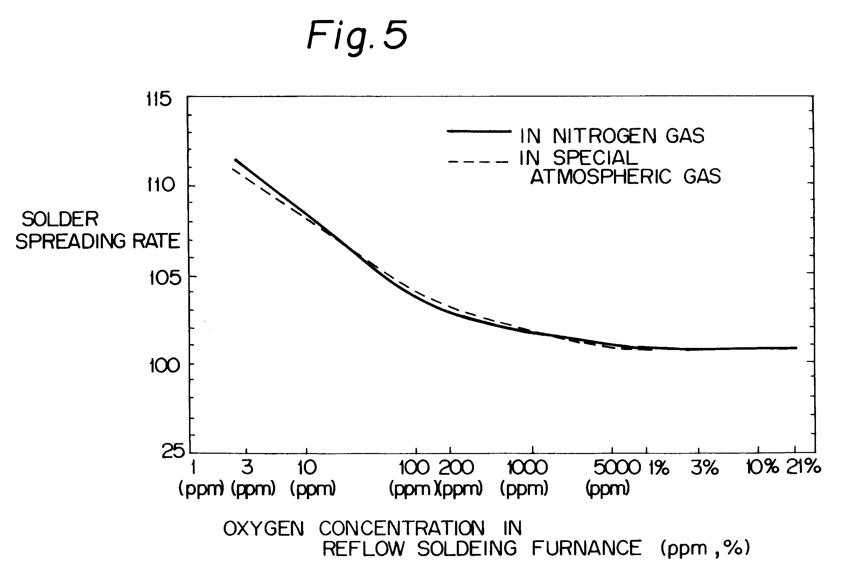

Figure 3 shows the number of solder balls, Figure 4 the soldered joint strength, and Figure 5 the solder spreading rate. The solid line and the dotted line in each of Figures 3 to 5 represent the results obtained in nitrogen gas and the special atmospheric gas, respectively.

The solder spreading rate showed no differences between nitrogen gas and the special atmospheric gas, while the number of solder balls and the soldered joint strength showed improvements in the case of the special atmospheric gas.

The following table reveals comparisons in terms of soldered joint strength between soldering in nitrogen gas and that in the special atmospheric gas (oxygen concentration 200 ppm, moisture content 1.5%), both at a furnace oxygen concentration of 200 ppm and with a cream solder thickness of 150»m or 100»m.

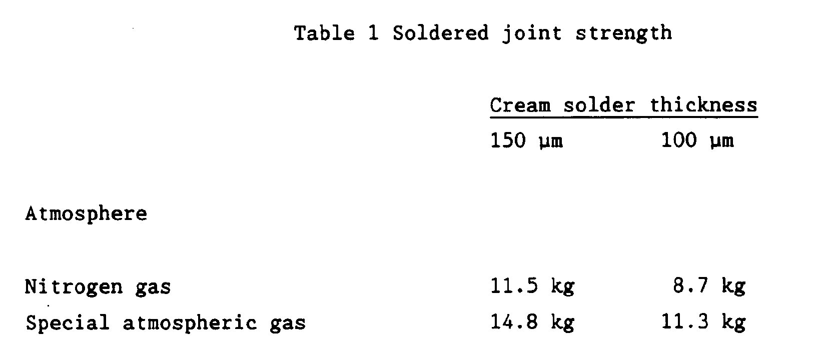

Oxygen concentration in the furnace: 200 ppm.

The smaller the pitch of the parts to be soldered, i.e. the closer they are to one another on the board, the less the amount of the cream solder that needs to be used and also the greater the tendency for more solder balls to be formed. By soldering in the special atmospheric gas, a higher joint strength can be secured even when the amount of the cream solder is decreased (solder thickness: 150»m → 100 »m).

In accordance with the method illustrated in Figure 1, a conventional rosin-based cream solder (including that for a "fine pitch") was reflow-soldered in a furnace atmosphere with an oxygen concentration of 3 ppm to 21%, a moisture content of 1.5%, and the remainder being nitrogen. Then, the number of solder balls, the soldered joint strength, and the solder spreading rate were measured.

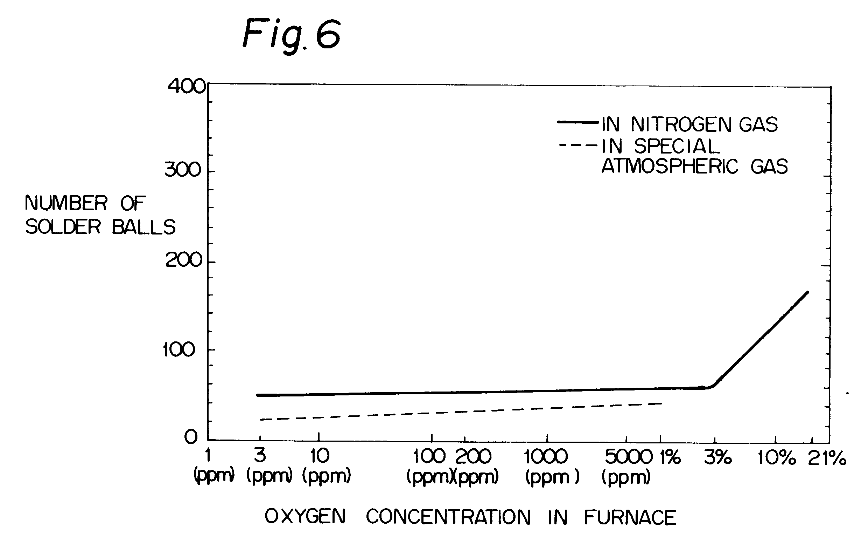

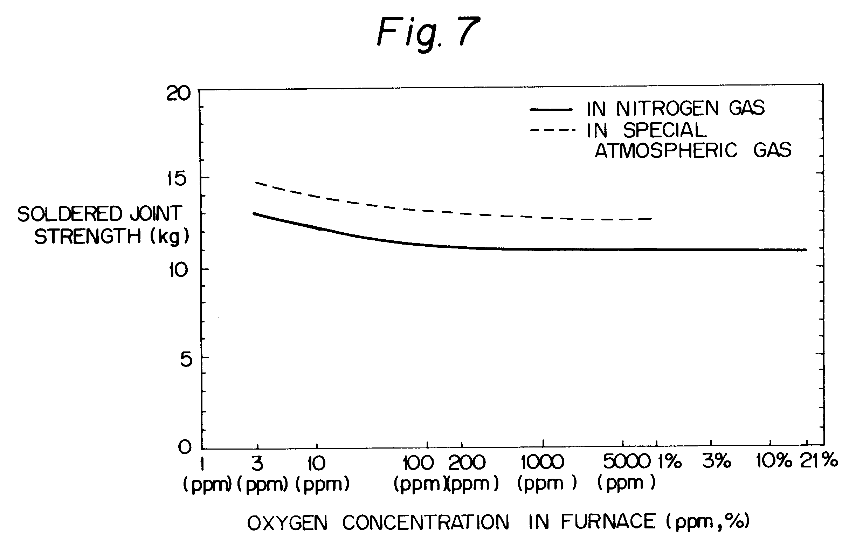

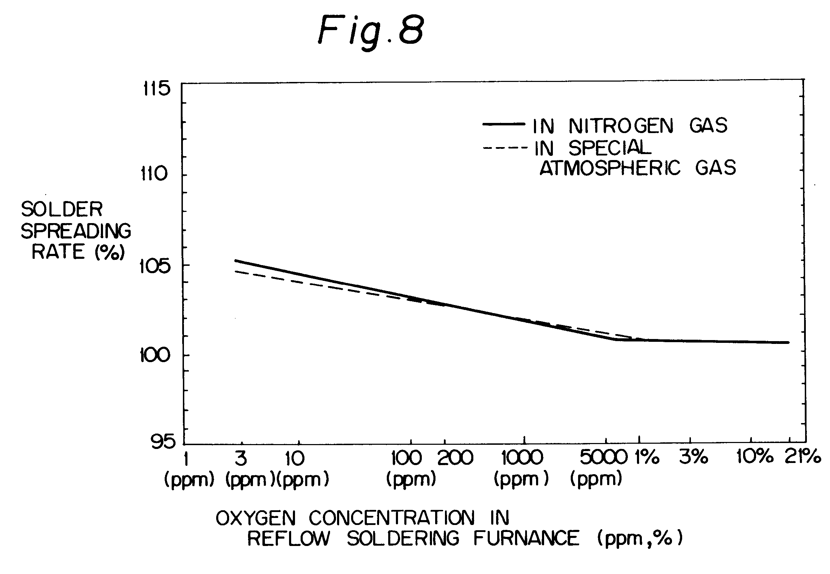

Figure 6 shows the number of solder balls, Figure 7 the soldered joint strength, and Figure 8 the solder spreading rate. The solid line and the dotted line in each of Figures 6 to 8 represent the results obtained in nitrogen gas and the special atmospheric gas, respectively.

The solder spreading rate showed no differences between nitrogen gas and the special atmospheric gas, while the number of solder balls and the soldered joint strength showed improvements in the case of the special atmospheric gas.

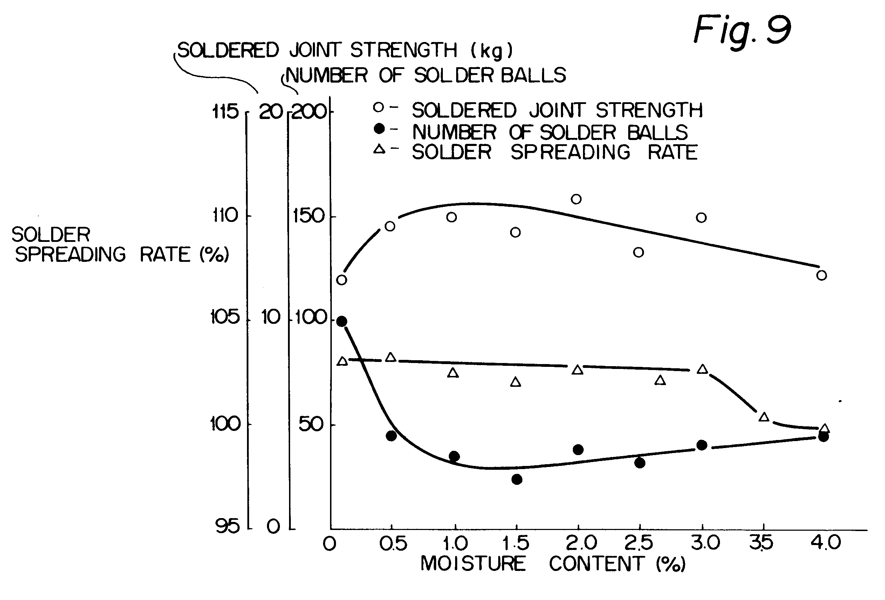

In accordance with the method illustrated in Figure 1, a rosin-based cream solder containing a flux with a low solids content was reflow-soldered with the oxygen concentration in the reflow soldering furnace being set at 200 ppm and the moisture content being changed as follows: 0.1, 0.5, 1.0, 1.5, 2.0, 2.5, 3.0 and 4.0%. Then, the number of solder balls, the soldered joint strength, and the solder spreading rate were measured. The number of solder balls decreased at a moisture content of 0.5% or more. The soldered joint strength increased at a moisture content of 0.5% or more. The solder spreading rate began to decrease at a moisture content of 3% or more. These results are shown in Figure 9.

## Claims

1. A method of joining a component to a printed circuit board, which comprises reflow soldering the component to the board with a rosin-based flux containing cream solder in a special atmospheric gas comprising an inert gas and containing 10,000 parts per million by volume or less of oxygen and 0.5-3.0% by volume of moisture.

2. A method according to Claim 1, in which the solder contains a flux with a low solids content.

3. A method according to Claim 1 or Claim 2, wherein said inert gas is selected from the group consisting of N₂, Ar and He.

## Patentansprüche

1. Ein Verfahren des Verbindens einer Komponente mit einer Leiterplatte, welches das Aufschmelzlöten der Komponente an die Platine mit einem ein Flußmittel enthaltenden Cremelot auf Harzbasis in einem speziellen atmosphärischen Gas umfaßt, das ein Inertgas umfaßt und 10000 Teile pro Million an Volumen oder weniger Sauerstoff und 0,5 - 3,0 Volumen% Feuchtigkeit enthält.

2. Ein Verfahren nach Anspruch 1,
in welchem das Lot ein Flußmittel mit einem niedrigen Feststoffgehalt enthält.

3. Ein Verfahren nach Anspruch 1 oder 2,
worin das Inertgas aus der Gruppe ausgewählt wird, die aus N₂, Ar und He besteht.

## Revendications

1. Procédé de jonction d'un composant à une plaquette de circuit imprimé, qui comprend le soudage ou le brasage du composant sur la plaquette, par fusion à l'aide d'une soudure sous forme de crème contenant un fondant à base de résine de colophane dans une atmosphère gazeuse spéciale comprenant un gaz inerte et contenant un nombre de parties en volume d'oxygène égal ou inférieur à 10 000 parties par million, et 0,5 à 3,0 % en volume d'humidité.

2. Procédé selon la revendication 1, dans lequel la soudure contient un fondant à faible teneur en des solides.

3. Procédé selon la revendication 1 ou la revendication 2, dans lequel ledit gaz inerte est choisi dans l'ensemble formé par N₂, Ar et He.
